Europäisches Patentamt

European Patent Office

Office européen des brevets

(19)

(11) Publication number: **0 136 204 B1**

# (12) EUROPEAN PATENT SPECIFICATION

(45) Date of publication of patent specification: **06.04.88**

(21) Application number: **84401606.3**

(22) Date of filing: **01.08.84**

(51) Int. Cl.⁴: **G 01 R 31/28**

(54) Control of signal timing apparatus in automatic test systems using minimal memory.

(30) Priority: **01.08.83 US 518499**

(43) Date of publication of application:
**03.04.85 Bulletin 85/14**

(45) Publication of the grant of the patent:
**06.04.88 Bulletin 88/14**

(84) Designated Contracting States:
**DE FR GB IT NL**

(56) References cited:
**US-A-4 044 244**

**INTERNATIONAL TEST CONFERENCE 1983,
CH1933-1/83, paper 8.5, 18th-20th October
1983, IEEE, USA; R.F. HERLEIN: "Optimizing
the timing architecture of a digital LSI test
system"**

**1981 INTERNATIONAL TEST CONFERENCE,
CH1693-1/81, 27th-29th October 1981, paper
7.5, pages 143-153, IEEE, USA; S. SUGAMORI
et al.: "Analysis and definition of overall timing
accuracy in VLSI test system"**

(73) Proprietor: **FAIRCHILD CAMERA &
INSTRUMENT CORPORATION
464 Ellis Street
Mountain View California 94042 (US)**

(72) Inventor: **Herlein, Richard F.
4237 Haines Avenue
San Jose California 95136 (US)**

(74) Representative: **Chareyron, Lucien et al
Schlumberger Limited Service Brevets c/o Giers
12, place des Etats Unis B.P. 121
F-92124 Montrouge Cédex (FR)**

Courier Press, Leamington Spa, England.

# Description

## Background of the Invention
### *Field of the Invention*

This invention relates to automatic test equipment for testing integrated circuits and the control of signal timing apparatus in such equipment. In particular, the invention relates to the control of apparatus for delaying electrical signals by desired time intervals in automatic test equipment.

### *Description of the Prior Art*

Automatic test systems for the testing of integrated circuits are well known and employed throughout the semiconductor industry. In such test systems a semiconductor device under test is subjected to patterns of stimuli signals, and the resultant output conditions are monitored and analyzed to determine the functionality and/or quality of the device being tested. As integrated circuit technology advances, the manufacturers of such automatic test systems must provide the capability of testing increasingly complex, very high speed circuits with a high degree of precision. In such test systems to assure the validity of the test results, the timing system must cause input signal transitions and output strobe signals to occur precisely at pre-programmed times at the device under test. A further complicating factor in such systems is that the signals being supplied to, and receiving from, the terminals of the device being tested, travel over many different paths through the system circuitry. Because the different paths have different propagation delays, the propagation delays must be corrected to assure that the patterns of test signals supplied, and that the output signals detected, are validly interpreted.

In prior art test systems the propagation differences were compensated for by the use of manually adjustable potentiometers. Adjustment of these potentiometers was a time consuming and expensive task.

U.K. Application GB 2 010 552 A shows a clock pulse circuit which can be controlled as to both pulse width and skew. Pulse width and skew are respectively controlled by separate channels each of which is controlled by a sequence of control bits stored in a set of latches for that channel. The control bits control the selection of a tap on a uniformly tapped delay line to control pulse width or skew. The circuit requires separate memory resources for each channel, in contrast to the present invention.

## Summary of the Invention

A more economical and efficient method of controlling the timing of signals in test systems is needed to enable adjustment of the timing of signals in a manner necessitated by the characteristics of the system and the circuit being tested. In co-pending European patent application 84401605.5, Publication number 0 136 203, entitled "Method and Apparatus for Dynamically Controlling the Timing of Signals in Automatic Test Systems", filed on the same date as this application, a dynamically controllable system is described for controlling the timing of signals in automatic test systems. The system described in that application provides apparatus for controllably delaying electrical signals, and includes a cascaded series of stages for "fine tuning" the timing of signals passing through the apparatus described. The system described herein provides apparatus for controlling the cascaded stages described in that application, in particular, by providing control signals for the cascaded timing elements.

In a preferred embodiment apparatus for supplying signals at a desired time includes first generating means for generating a first signal in response to a first control signal and a second control signal; first delay means connected to receive the first signal and delay it by an amount determined by a third control signal; a base delay memory for storing at least one sequence of bits extending from a most significant bit to include a lesser significant bit, the base delay memory being connected to supply the first control signal; and a first vernier memory for storing at least one sequence of bits extending from a bit of the same power as the lesser significant bit to a least significant bit, the vernier memory being connected to supply the first generating means with the second control signal in response to the lesser significant bit and to supply the first delay means with a third control signal.

In the preferred embodiment the first generating means is a counter controlled by a twenty bit wide base delay memory. The first vernier memory is an eleven bit wide memory whose most significant bit has the same significance as the least significant bit of the twenty bit wide base delay memory. The first control signal is a function of the contents of the twenty bit wide base delay memory, while the third control signal is a function of the contents of the ten least significant bits of the vernier memory. The second control signal is determined by the contents of the most significant bit of the vernier memory.

The invention is particularly advantageous because it permits control of several signal timing paths using substantially less memory resources than required if each signal timing path were to have its own dedicated memory.

## Brief Description of the Drawings

Figure 1 is a block diagram illustrating a preferred embodiment of the invention.

Figure 2 is a block diagram illustrating an application of the invention to the generation of timing signals in automatic test systems.

## Detailed Description of the Preferred Embodiment

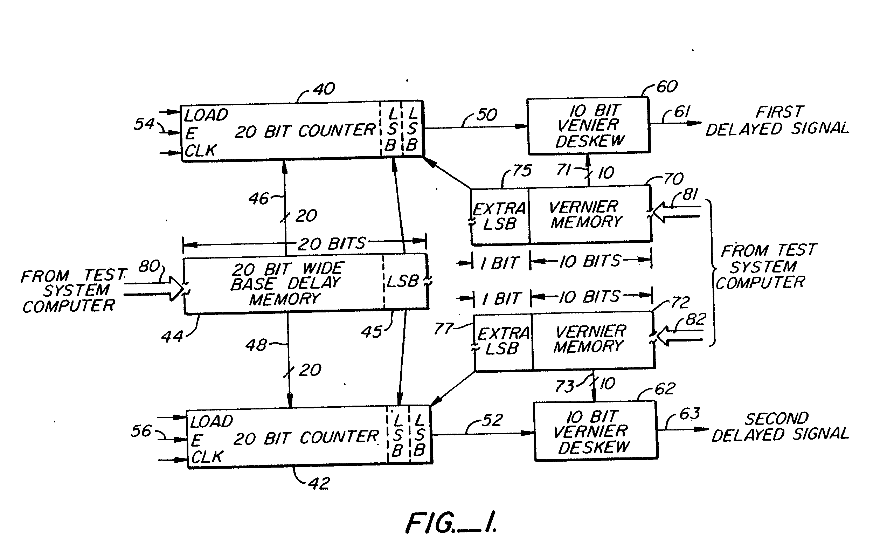

The apparatus shown in Figure 1 provides a technique for generating first and second delayed signals at desired times, which times are precisely controllable by the automatic test system with an extremely high degree of accuracy. As such, the system depicted enables compensation for the propagation differences in the paths followed by the first and second delayed signals. In the apparatus shown, each of counters 40 and 42 are controlled by data stored in a twenty bit wide base delay memory 44. Memory 44 will contain information as to the "rough" magnitude of the delay to be applied to the signals, that is, the more significant bits of the digital representation of the value of the time delay. This information is transmitted to counter 40 via bus 46 and to counter 42 via bus 48. In response to the information supplied from base delay memory 44, and when enabled via signals received on lines 54 and 56, respectively, counters 40 and 42 will supply an output signal over lines 50 and 52, respectively. The actual timing of the output signals from the counters is determined by one or more clock signals supplied to the counters. In effect the counters control signal paths to pass timing signals at the appropriate instant.

The output signals from counters 40 and 42 are received by vernier delay apparatus 60 and 62, respectively. Each of the verniers 60 and 62 delay the signal received on their respective incoming lines 50 and 52 for a time determined by the contents of vernier memories 70 and 72. The contents of each of these memories, in turn, is determined by data from the test system computer. Each vernier memory may be as "deep" as desired, that is, may contain information for the time delays to be imposed in a sequence of test system operations. The vernier memories communicate over buses 71 and 73 with the verniers signal delay apparatus 60 and 62. Each of vernier delay apparatus 60 and 62 will delay the signal received on incoming lines 50 and 52 by a time determined by the information supplied on lines 71 and 73. The specific manner in which vernier deskew elements 60 and 62 operate is described in detail in co-pending European patent application 84401605.5, Publication Number 0 136 203, entitled "Method and Apparatus for Dynamically Controlling the Timing of Signals in Automatic Test Systems", and filed on the same date as this application. In that application a system of four deskew elements are cascaded to provide wide ranging accurate control of signal timing. The four elements combined are referred to herein as vernier delay deskew elements to differentiate them from the counters, but it should be understood these verniers may be other well known apparatus, and as many or few as desired cascaded together. The ultimate accurately delayed signals will be supplied to any desired apparatus on line 61 and 63 as shown. In a preferred embodiment the signals on lines 61 and 63 are two phases of the same signal.

Of particular advantage to the apparatus of this invention is the feature that a single base delay memory 44 may be used to control many signal paths, with separate vernier memories used for the individual signal paths to precisely control the timing of the signals there. In the embodiment shown in Figure 1 the base delay memory is used to control two counters, 40 and 42, and hence two signal paths, however, as many counters and signal paths as desired could be controlled, with the ultimate number depending only upon the number of signal paths on which delayed signals are desired at times within the range of the significance of the bits stored in the base delay memory 44.

Each of the vernier memories 70 and 72 include a most significant bit 75 and 77 which is a duplicate in terms only of significance of the least significant bit of base delay memory 44. The word duplicate is used herein to means duplicative of the magnitude of the least significant bit of base delay memory 44, but not necessarily duplicative of the actual contents of the least significant bit 45 of base delay memory 44. For example, for the specific embodiment illustrated in Figure 1 bits 75 and 77 of correction memories 70 and 72 would represent $2^{10}$, as would least significant bit 45 of memory 44. That is, a logical one in bit register 75 would represent $1 \times 2^{10}$ while a logical zero in register 75 would represent $0 \times 2^{10}$. Similarly a one in register 45 would also represent $1 \times 2^{10}$, and a zero would represent $0 \times 2^{10}$. In this manner a carry from the ten bits of correction memory 70 is not propagated into the base delay memory 44 but is propagated and stored in register 75 as an extra least significant bit of the same power of two as the least significant bit 45 in base delay memory 44. In some embodiments of the invention the significance of the bits may control the vernier in a non-binary manner, that is, a bit may not provide a delay twice that of a next less significant bit.

The apparatus of Figure 1 operates in the following manner. Data from the test system computer is loaded into base delay memory 44 via bus 80, into vernier memory 70 over bus 81, and into vernier memory 72 over bus 82. Typically each of these memories is many bits deep with each "row" of bits representative of the desired delay for a particular test, and with the collective memory representative of the desired delays for a sequence of many tests. In a well known manner the contents of the base delay memory 44 are loaded into counters 40 and 42 to provide data indicative of the approximate time at which delayed signals 61 and 63 are to be supplied. For the example depicted, the approximate time is the twenty most significant bits of a time specified to thirty bit accuracy. Of course each bit can represent any desired time interval, but in the preferred embodiment, the contents of the least significant bit register of each of correction memories 70 and 72 represents ten picoseconds, while the contents of the least significant bit 45 of base delay memory 44 represents 5 nanoseconds.

In the preferred embodiment counters 40 and 42 will permit clock signals to be supplied on lines 50 and 52 when a terminal count is reached. A terminal count is reached whenever the contents of all stages of the counter are zero. Thus if the extra least significant bits 75 and 77 of vernier memory 70 and 72 are zero, and other bits supplied from base delay memory 44 are not zero, the other bits are counted down to zero in a binary fashion and a signal supplied on lines 50 and 52. If the extra least significant bits 75 and 77 are one, they are first counted to zero, then all other bits of the counter are counted down to zero, including, any bit stored in register 45. After a signal is supplied the test system computer loads a one into the least significant bit 45 to prevent the counters 40 and 42 from sending other output pulses on lines 50 or 52 until the counter is properly reloaded from a desired "row" of base delay memory 44, and/or to enable reloading of the memories.

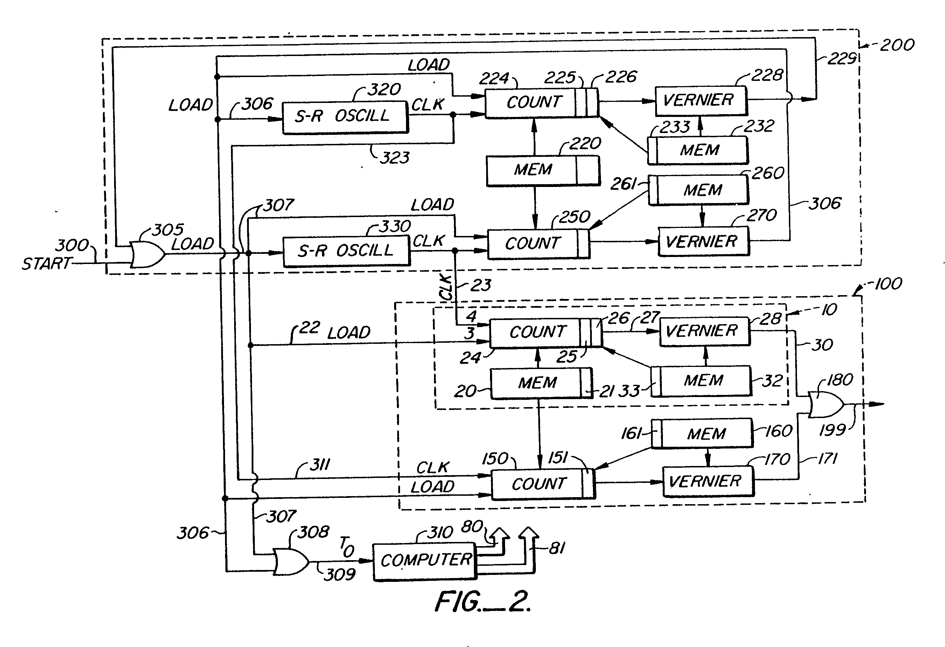

The apparatus of Figure 2 illustrates one application for the system depicted in Figure 1. A pulse generator 10 in timing edge generator 100 includes a base delay memory 20 having a first bit width, preferably 20 columns, a depth of preferably 16 rows, and a counter 24 having 20 binary bits and responsive to a duplicate LSB 26. Generator 10 also includes a pulse delay vernier 28 of preferably 10 bits resolution, and a vernier memory 32 one bit wider than the vernier and the same depth as memory 20.

As explained above, the power of the most significant bit 33 in vernier memory 32 is duplicated in the least significant bit 21 in memory 20. The most significant bit 33 is loaded into register 26 of counter 24 which allocates the same effect to bits 25 and 26. When counter 24 is clocked to zero it produces a pulse on line 27 which is delayed by a desired interval by vernier deskew apparatus 28 in response to the correction supplied by the remaining bits of memory 32.

Timing edge generator 100 generates pulses in two phases, each referenced to a time $T_0$. The pulses can occur close to or even later than the next $T_0$. The phase outputs are combined by OR gate 180 and supplied on output line 199. Because the corrections for the two phases are generally different, a two phase generator could require separate thirty bit memories to store the separate timing data. As discussed above, however, the present invention eliminates the need for extra memory because carries from the correction values in memories 32 and 160 are not propagated through to the base timing data in memory 20. Hence, the memory 20 serves both counters 24 and 150 in two phase timing edge generator 100.

The counter, vernier delay apparatus, and memory arrangement 10 is also used in period generator 200. To support the two-phase timing edge generator 100, period generator 200 also uses two counters 224 and 250 and two verniers 228 and 270. The pulse generator circuit including memory and registers is duplicated to allow pulse generation by one circuit while the other circuit is loaded with a new value and restarted. Stop-restart oscillators 320 and 330 supply clock signals carrying the timing information to all counters.

Before the test system can accurately test integrated circuits, the pulse generators must be calibrated. To calibrate, the most significant bits of the programmed delays are loaded into memories 20 and 220. If the oscillator frequency is 200 megahertz, the most significant bits of these memories will represent a value of the desired period divided by 5 nanoseconds, minus any remaining fraction. The less significant bits representing the remaining fraction are loaded into the vernier memories. A start pulse is applied to line 300, and the synchronization errors between the arrival of pulses at output terminals of pulse generator circuits for others of the pins on the integrated circuit being tested are measured. Correction values are calculated, to replace values stored in the vernier memories 32, 160, 232, 260. These corrections may result in a binary 1 in the eleventh and most significant bits 33, 61, 233, and/or 261 of the correction memories.

Once calibrated, the base delay and correction memories are loaded by the test system computer. A start pulse applied to line 300 passes through OR gate 305 to provide a "load" signal on line 307. Load signals are combined by OR gate 308 to form the period signal $T_0$ on line 309. The test system computer uses the period signal $T_0$ to select addresses for appropriate delays from a range of 16 values stored in the 16 rows of memories 20 and 220. The load signals 306 and 307 are respectively applied to the counters 150 and 224, and 24 and 250, to load the selected values from memories 20 and 220. The load signals 306 and 307 also activate stop-restart oscillators 320 and 330, which supply clock pulses with a five nanosecond period on lines 323 and 23, respectively. The clock pulses count down their respective counters, which will typically contain different values.

When a counter has counted down to zero, it supplies a pulse whose timing is determined by the 5 nanosecond period of the oscillator. The pulse is delayed again by an appropriate amount and controlled to a resolution of 10 picoseconds by the respective vernier.

The vernier in each half of period generator 200 is also coupled to the stop restart oscillator for the other half of the period generator. Each time a pulse emerges from OR gate 305, the output signal passes through OR gate 308 as T0 signal on line 309, which, when supplied to the test system computer causes it to select new memory addresses thereby accessing the next period and timing edge data.

The timing edge generator counters are loaded and clocked by the same pulses as activate the corresponding phase of the period generator. The verniers must also be loaded, typically after the counters to minimize deadtime. The output signals from timing edge generator verniers 28 and 170 are combined by OR gate 180 to form the timing edge pulse train on line 199. The single two-phase timing edge generator 100 shown in Figure 2 is generates an average of one timing pulse per period. The period generator may also support more than one timing edge generator 100 so that two or more timing edges per period may be generated, even on the same output line.

## Claims

1. Apparatus for supplying signals at a desired time comprising a first generating means generating a first signal, a first delay means being connected to receive said first signal and delay it by an amount determined by the contents of a memory storing a sequence of bits extending from a most significant bit to include a lesser significant bit characterized by:
said first generating means (24; 224) supplying said first signal (27) in response to at least a first control signal and a second control signal (23; 323);
said first delay means (28; 228) delaying said first signal by an amount determined by a third control signal;
said memory comprising a base delay memory (20; 220) connected to supply the first control signal; and
a first vernier memory (32; 232) for storing at least one sequence of bits extending from a first bit of equal significance of the lesser significant bit to a first least significant bit, the vernier memory being connected to supply the first generating means (24; 224) with the second control signal in response to the first bit of equal significance of the lesser significant bit and to supply the first delay means (28; 228)·with the third control signal in response to all but the first bit of equal significance of the lesser significant bit.

2. Apparatus as in claim 1 characterized in that the first generating means (24; 224) comprises first counting means connected to a first source (330) of clock signals.

3. Apparatus as in claim 2 characterized in that the first signal comprises at least one of the clock signals from the first source of clock signals.

4. Apparatus in claim 1, 2 or 3 characterized by:
second generating means (150; 250) for supplying a second signal in response to the first control signal and a fourth control signal (311; 23);
second delay means (170; 270)· connected to receive the second signal and delay it by an amount determined by a fifth control signal; and
a second vernier memory (160; 260) for storing at least one sequence of bits extending from a second bit of equal significance of the lesser significant bit to a second least significant bit, the second vernier memory being connected to supply the second generating means (150; 250) with the fourth control signal in response to the second bit of equal significance of the lesser significant bit and to supply the second delay means with the fifth control signal in response to all but the second bit of equal significance of the lesser significant bit.

5. Apparatus as in claim 4 characterized in that the second generating means (150; 250) comprises second counting means connected to a second source of clock signals.

6. Apparatus as in claim 5 characterized in that the second signal comprises at least one of the clock signals from the second source of clock signals.

7. Apparatus as in claim 4, 5 or 6 characterized in that:
the base delay memory (20; 220) stores n sequences of bits; and
each of the first (32; 232) and second (160; 260) vernier memories also store n sequences of bits.

8. Apparatus as in any one of claims 4—7 characterized in that an OR gate (180) is connected to receive a first delayed signal from the first delay means (28) and a second delayed signal (171) from the second delay means (170) to thereby supply a leading edge signal (199).

## Patentansprüche

1. Vorrichtung zum Liefern von Signalen zu einer gewünschten Zeit, umfassend einen ersten Generator zum Erzeugen eines ersten Signals, ein erstes Verzögerungsglied, das angeschlossen ist zum Empfang des genannten ersten Signals und dessen Verzögerung um eine Zeitspanne, festgelegt durch den Inhalt eines Speichers, der eine Sequenz von Bits speichert, die sich von einem höchststelligen Bit bis zu einem niedrigerstelligen Bit erstreckt, dadurch gekennzeichnet,
daß der erste Generator (24; 224) das erste Signal (27) im Ansprechen auf zumindest ein erstes Steuersignal und ein zweites Steuersignal (23; 323) liefert,
daß das erste Verzögerungsglied (28; 228) das erste Signal um eine Zeitspanne verzögert, die durch ein drittes Steuersignal festgelegt ist,
daß der Speicher einen Basisverzögerungsspeicher (20; 220) umfaßt, angeschlossen zum Liefern des ersten Steuersignals und
daß ein erster Vernier Speicher (32; 232) vorgesehen ist für das Speichern zumindest einer Sequenz von Bits, die sich von einem ersten Bit gleichen Stellenwerts wie das niedrigerstellige Bit bis zu einem ersten niedrigstelligen Bit erstreckt, welcher Vernier Speicher angeschlossen ist zum Liefern des zweiten Steuersignals an den ersten Generator (24; 224) im Ansprechen auf das erste gleichstellige Bit des niedrigerstelligen Bits und zum Anspeisen des ersten Verzögerungsgliedes (28; 228) mit dem dritten Steuersignal im Ansprechen auf alle Bits mit Ausnahme des ersten gleichstelligen Bits bezüglich des niedrigerstelligen Bits.

2. Vorrichtung nach Anspruch 1, dadurch gekennzeichnet, daß der erste Generator (24; 224) einen ersten Zähler umfaßt, angeschlossen an eine erste Quelle (330) von Taktsignalen.

3. Vorrichtung nach Anspruch 2, dadurch gekennzeichnet, daß das erste Signal mindestens eines der Taktsignale von der ersten Quelle von Taktsignalen umfaßt.

4. Vorrichtung nach Anspruch 1, 2 oder 3, gekennzeichnet durch einen zweiten Generator (150; 250) für die Lieferung eines zweiten Signals im Ansprechen auf das erste Steuersignal und ein viertes Steuersignal (311; 23),
ein zweites Verzögerungsglied (170; 270), angeschlossen zum Empfang des zweiten Signals und seiner Verzögerung um eine Zeitspanne, festgelegt durch ein fünftes Steuersignal, und

einen zweiten Vernier Speicher (160; 260) für die Speicherung mindestens einer Sequenz von Bits, die sich von einem zweiten gleichstelligen Bit bezüglich des niedrigerstelligen Bits bis zu einem zweiten niedrigststelligen Bit erstreckt, wobei der zweite Vernier Speicher angeschlossen ist zum Anspeisen des zweiten Generators (150; 250) mit dem vierten Steuersignal im Ansprechen auf das zweite gleichstellige Bit bezüglich des niedrigerstelligen Bits und für die Anspeisung des zweiten Verzögerungsgliedes mit dem fünften Steuersignal im Ansprechen auf alle außer dem zweiten gleichstelligen Bit bezüglich des niedrigerstelligen Bits.

5. Vorrichtung nach Anspruch 4, dadurch gekennzeichnet, daß der zweite Generator (150; 250) einen zweiten Zähler umfaßt, angeschlossen an eine zweite Quelle von Taktsignalen.

6. Vorrichtung nach Anspruch 5, dadurch gekennzeichnet, daß das zweite Signal mindestens eines der Taktsignale von der zweiten Quelle von Taktsignalen umfaßt.

7. Vorrichtung nach Anspruch 4, 5 oder 6, dadurch gekennzeichnet, daß der Basisverzögerungsspeicher (20; 220) n Sequenzen von Bits speichert und

daß jeder der ersten (32; 232) und zweiten (160; 260) Vernier Speicher ebenfalls n Sequenzen von Bits speichert.

8. Vorrichtung nach einem der Ansprüche von 4 bis 7, dadurch gekennzeichnet, daß ein ODER-Gatter (180) angeschlossen ist zum Empfang eines ersten verzögerten Signals von dem ersten Verzögerungsglied (28) und eines zweiten verzögerten Signals (171) von dem zweiten Verzögerungsglied (170), um so ein Anstiegsflankensignal (199) zu liefern.

## Revendications

1. Dispositif pour fournir des signaux à un instant désiré comprenant des premiers moyens générateurs élaborant un premier signal, des premiers moyens à retard étant connectés pour recevoir ledit premier signal et le retarder d'une quantité déterminée au moyen du contenu d'une mémoire stockant une séquence de bits commençant à un bit dit le plus significatif et incluant un bit dit moins significatif, caractérisé en ce que:

lesdits premiers moyens générateurs (24; 224) fournissent ledit premier signal (27) en réponse à au moins un premier et un deuxième (23; 323) signal de commande;

les premiers moyens à retard (28; 228) retardent ledit premier signal d'une quantité déterminée par un troisième signal de commande;

ladite mémoire comprend une mémoire de retard de base (20; 220) connectée pour fournir le premier signal de commande; et

une première mémoire vernier (32; 232) stocke au moins une séquence de bits commençant à un premier bit de même ordre que le bit dit moins significatif et se terminant à un bit appelé premier bit le moins significatif, la mémoire vernier étant connectée pour fournir aux premiers moyens générateurs (24; 224) le deuxième signal de commande en réponse audit premier bit de même ordre que le bit dit moins significatif et pour fournir aux premiers moyens à retard (28; 228) le troisième signal de commande en réponse à tous les bits à l'exception dudit premier bit de même ordre que le bit dit moins significatif.

2. Dispositif selon la revendication 1, caractérisé en ce que lesdits premiers moyens générateurs (24; 224) comprennent des premiers moyens de comptage connectés à une première source (330) de signaux d'horloge.

3. Dispositif selon la revendication 2, caractérisé en ce que le premier signal comprend au moins un des signaux d'horloge provenant de la première source de signaux d'horloge.

4. Dispositif selon la revendication 1, 2 ou 3, caractérisé par:

des deuxièmes moyens générateurs (150; 250) pour fournir un deuxième signal en réponse au premier signal de commande et à un quatrième signal de commande (311; 23);

des deuxièmes moyens à retard (170; 270) connectés pour recevoir le deuxième signal et le retarder d'une quantité déterminée par un cinquième signal de commande; et

une deuxième mémoire vernier (160; 260) pour stocker au moins une séquence de bits commençant à un deuxième bit de même ordre que le bit dit moins significatif et se terminant à un bit appelé deuxième bit le moins significatif, la deuxième mémoire vernier étant connectée pour fournir aux deuxièmes moyens générateurs (150; 250) le quatrième signal de commande en réponse audit deuxième bit de même ordre que le bit dit moins significatif et pour fournir aux deuxièmes moyens à retard le cinquième signal de commande en réponse à tous les bits à l'exception dudit deuxième bit de même ordre que le bit dit moins significatif.

5. Dispositif selon la revendication 4, caractérisé en ce que les deuxième moyens générateurs (150; 250) comprennent des deuxièmes moyens de comptage connectés à une deuxième source de signaux d'horloge.

6. Dispositif selon la revendication 5, caractérisé en ce que le deuxième signal comprend au moins un des signaux d'horloge provenant de la deuxième source de signaux d'horloge.

7. Dispositif selon la revendication 4, 5 ou 6, caractérisé en ce que:

la mémoire de retard de base (20; 220) stocke n séquences de bits; et

chacune des première (32; 232) et deuxième (160; 260) mémoires vernier stocke aussi n séquences de bits.

8. Dispositif selon l'une des revendications 4 à 7, caractérisé en ce qu'une porte OU (180) est connectée pour recevoir un premier signal retardé provenant des premiers moyens à retard (28) et un deuxième signal retardé (171) provenant des deuxièmes moyens à retard (170) pour fournir un signal de front avant (199).

FIG._1.

FIG._2.